# EUROPÄISCHE PATENTSCHRIFT

(11) **EP 0 919 819 B1**
(45) Veröffentlichungstag und Bekanntmachung des Hinweises auf die Patenterteilung: **17.04.2002**
(21) Anmeldenummer: 98121929.8
(22) Anmeldetag: 19.11.1998
(51) Int. Cl.: G01R 23/16

(54) **Verfahren und Vorrichtung zur Messsignalauswertung**
Procedure and device for evaluating measurement signals
Procédé et appareil pour evaluation des signaux de mesure

(30) Priorität: 19.11.1997 DE 19751218
(43) Veröffentlichungstag der Anmeldung: 02.06.1999
(73) Patentinhaber: Schenck Vibro GmbH, 64293 Darmstadt (DE)
(72) Erfinder: Sonnenschein, Roland Dr., 64839 Münster (DE)
(74) Vertreter: Behrens, Helmut, Dipl.-Ing.

(56) Entgegenhaltungen:
- EP-A- 0 343 906
- EP-A- 0 399 704
- DE-A- 19 515 712
- US-A- 4 630 228

## Beschreibung

Die Erfindung betrifft ein Verfahren zur Meßsignalauswertung gemäß dem Oberbegriff des Patentanspruchs 1 und eine Vorrichtung zur Durchführung dieses Verfahrens gemäß dem Oberbegriff des Patentanspruchs 2.

Bei der Erfassung von elektrischen analogen Signalen steht zur Auswertung dieser Signale vorher in der Regel nicht fest, welche Frequenzen in diesen Signalen enthalten sind und mit welchen Intensitäten diese Frequenzen in den Signalen vorkommen. Insbesondere bei der Erfassung von analogen Meßsignalen ist es häufig zur Auswertung notwendig, das in dem Meßsignal enthaltene Frequenzspektrum und deren Intensität zu ermitteln.

Aus der DE 43 27 291 C2 ist ein Verfahren und eine Vorrichtung zur Bestimmung von Meßgrößen einer Zentrifuge bekannt. Hier wird mit Hilfe eines Schwingungssensors, der an einem Gehäuse einer Zentrifuge angebracht ist, das Schwingungsverhalten der Zentrifuge erfaßt. Um nun die Meßgröße wie Drehfrequenz, Feststoffgehalt oder andere Betriebsparameter bestimmen zu können, wird aus den erfaßten analogen Schwingungssignalen mit Hilfe einer Fast-Fourier-Transformation deren Frequenzspektrum gebildet und aus dem Frequenzspektrum einzelne Frequenzen isoliert und deren Intensität bestimmt. Wie diese Signalauswertung im einzelnen durchgeführt wird, ist bei diesem vorbekannten Verfahren nicht offenbart.

Insbesondere wenn es bei der Bestimmung der zu isolierenden Frequenzen und deren Intensität auf hohe Genauigkeit ankommt, besteht die Schwierigkeit, daß die Auswertung auf einem endlichen Signalabschnitt beschränkt werden muß. Ist dieser Erfassungszeitraum nicht periodisch, so tritt eine spektrale Verbreiterung (Leakage-Effekt) auf, die häufig zu Fehlern in der ermittelten Frequenz und deren Intensität führt.

Derartige Fehler bei den analysierten Signalen können zwar häufig durch die Synchronisation mit einem Triggersignal vermieden werden, erfordern aber eine zusätzliche Hardware und stehen häufig aus technischen Gründen auch nicht zur Verfügung. Bei Auswerteverfahren, bei denen eine derartige Synchronisation der Erfassungszeiträume nicht möglich ist, kann diese spektrale Verbreiterung durch eine Überlagerung mit einer "Fenster-Funktion" auf ein bestimmtes Maß reduziert werden.

Aus der EP 0 399 704 A2 ist ein Analysator zur Ermittlung der Amplituden und der Spektrallinie eines Frequenzspektrums bekannt. Dieser Analysator ermittelt die Amplituden und die Scheitelfrequenzen mit Hilfe eines sogenannten "Gauß-Fensters", nach dem die Amplituden und deren Frequenzen mathematisch exakt berechen- und darstellbar sind. Allerdings bietet diese Analyse mit Hilfe des Gauß-Algorithmus nur eine begrenzte Trennschärfe, die für verschiedene Meßsignalauswertungen insbesondere bei sehr kurzzeitigen Meßzeitintervallen nicht ausreichend ist.

Eine aus der "Grundlagen der dynamischen Signalanalyse", 1991, Seiten 36 bis 37, Hewlett Packard, Application Note 243, Böblingen bekannte Fensterfunktion ist das sogenannte "Hanning-Fenster". Dabei wird der analysierbare Zeitebenen-Signalabschnitt mit einer Gewichtsfunktion multipliziert, die zu Beginn des Signalabschnitts den Wert 0 und in der Mitte des Signalabschnitts ihr Maximum hat. Das Verfahren nach dem "Hanning-Fenster" ist eine Standard-Fensterfunktion, insbesondere bei Rauschleistungsmessungen und ist mathematisch gesehen eine invertierte Cosinus-Glocke. Dieses Verfahren hat allerdings den Nachteil, daß Frequenzen, die nicht exakt mit einer der Filter-Mittenfrequenzen übereinstimmen, einen relativ großen Fehler aufweisen. Denn, wenn eine Komponente zwischen zwei Mittenfrequenzen liegt, beträgt der Intensitätsfehler der analysierten Frequenz nach dem "Hanning-Fenster" ca. 16 %.

Ein weiteres aus der "Grundlagen der dynamischen Signalanalyse", 1991, Seiten 36 bis 37, Hewlett Packard, Application Note 243, Böblingen bekanntes Verfahren zur Gewichtung des Signalabschnitts stellt das sogenannte "Flattop-Fenster" dar. Dieses Verfahren reduziert zwar den Amplitudenfehler auf ca. 1,2 %, liefert aber nur eine wesentlich geringere Frequenzauflösung.

Der Erfindung liegt deshalb die Aufgabe zugrunde, ein Verfahren und eine Vorrichtung der eingangs genannten Art so zu verbessern, daß bei der Signalauswertung sowohl der Fehler in der Frequenzermittlung als auch in der Intensitätsermittlung verringert wird.

Diese Aufgabe wird durch die in Patentanspruch 1 und Patentanspruch 2 angegebene Erfindung gelöst. Weiterbildungen und vorteilhafte Ausführungsbeispiele der Erfindung sind in den Ansprüchen angegeben.

Die Erfindung hat den Vorteil, daß das erfinderische Signalauswerteverfahren auch bei kleinen Beobachtungszeiträumen durch die Interpolation zu sehr hohen Genauigkeiten in der Amplitude und der analysierten Frequenz führt. Darüber hinaus ist dieses Verfahren auch noch bei geringerem Abstand der Spektrallinien sehr genau.

Bei der parabolischen Interpolation ergeben sich in vorteilhafter Weise sehr genaue Werte der Intensität und Frequenz. Dies wird durch die Asymmetriekorrektur insbesondere auch für Spektrallinien erreicht, bei der die analysierte Frequenz nicht auf dem Frequenzraster liegt.

Die Erfindung wird anhand eines Ausführungsbeispiels, das in der Zeichnung dargestellt ist, näher erläutert. Es zeigen:
- Fig. 1:: eine schematische Darstellung einer Meßkette zur Schwingungsanalyse an Maschinen, und
- Fig. 2:: eine grafische Darstellung eines Frequenzspektrums mit Rekonstruktion der Scheitelwerte.

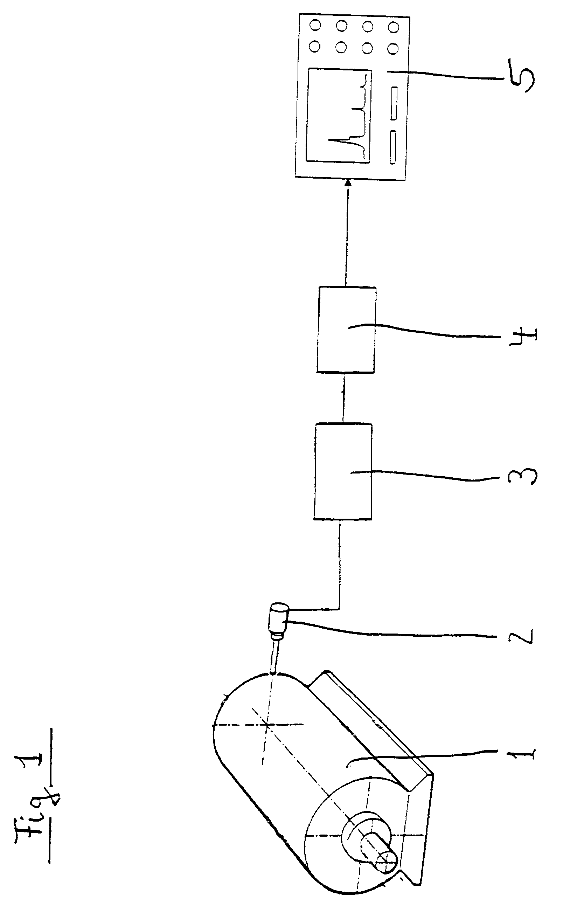

In Fig. 1 der Zeichnung ist die Ausführung einer Meßkette zur Maschinenüberwachung schematisch dargestellt, bei der an einer rotierenden Maschine 1 ein Schwingungsaufnehmer 2 angeordnet ist, dessen analoges Meßsignal einem Spektrum-Analysator 3 zugeführt wird, wobei nachfolgend eine elektronische Auswertevorrichtung 4 zur Ermittlung der Analyse-Frequenz und Rekonstruktion der Scheitelwerte vorgesehen ist, deren Ergebnis auf einer nachfolgenden Anzeigevorrichtung 5 dargestellt wird.

Die dargestellte Meßkette dient zur Fehlerdiagnose an rotierenden Maschinen 1. Mit einer derartigen Meßkette lassen sich beispielsweise auch anbahnende Schäden bereits im Stadium ihrer Entstehung erkennen. So äußert sich ein anbahnender Maschinenschaden frühzeitig in einer Änderung des Frequenzspektrums, und zwar noch bevor dies mit anderen Auswertemethoden aufgedeckt werden kann. Dabei kann es insbesondere wichtig sein, eine genaue Frequenzangabe und Amplitude zu erhalten, um nicht falsche Schlüsse zu ziehen.

An der rotierenden Maschine 1 als Meßobjekt ist ein Sensor 2 in Form eines Schwingungsaufnehmers angebracht, der das Schwingungsverhalten permanent oder für bestimmte Zeitabschnitte aufnimmt. Dieser Sensor 2 kann fest angebracht oder auch als beweglicher Aufnehmer an der Maschine 1 angeordnet sein. Das analoge Schwingungssignal wird einem Spektrum-Analysator 3 zugeführt, der das analoge Signal mit einer vorgegebenen Abtastfrequenz abtastet. Der Spektrum-Analysator 3 ist als elektronische Schaltung ausgebildet und enthält noch weitere bekannte Abtast/Halte-Schaltungen, A/D-Wandler, Filter und Verstärker, die hier nicht weiter beschrieben sind. Weiterhin enthält der Spektrum-Analysator 3 noch eine elektronische Schaltung bzw. einen Prozessor, der mittels Fast-Fourier-Transformation (FFT) das abgetastete Meßsignal in den Frequenzbereich transformiert. Da der FFT-Algorithmus auf der Annahme basiert, daß das Signal ohne Anfang und Ende vorkommt und in der Praxis aber immer nur ein endlicher Signalabschnitt erfaßbar ist, tritt bei nichtperiodischen Erfassungszeiträumen eine spektrale Verbreiterung (Leakage-Effekt)auf, der zu Meßfehlern führt. Deshalb wird das Eingangssignal des Spektrum-Analysators 3 einer Rechenschaltung zugeführt, die den Zeitdatensatz nach einer bekannten Fensterfunktion nach "Hanning" gewichtet, indem eine bestimmte Multiplikation (invertierte Cosinus-Glocke) durchgeführt wird.

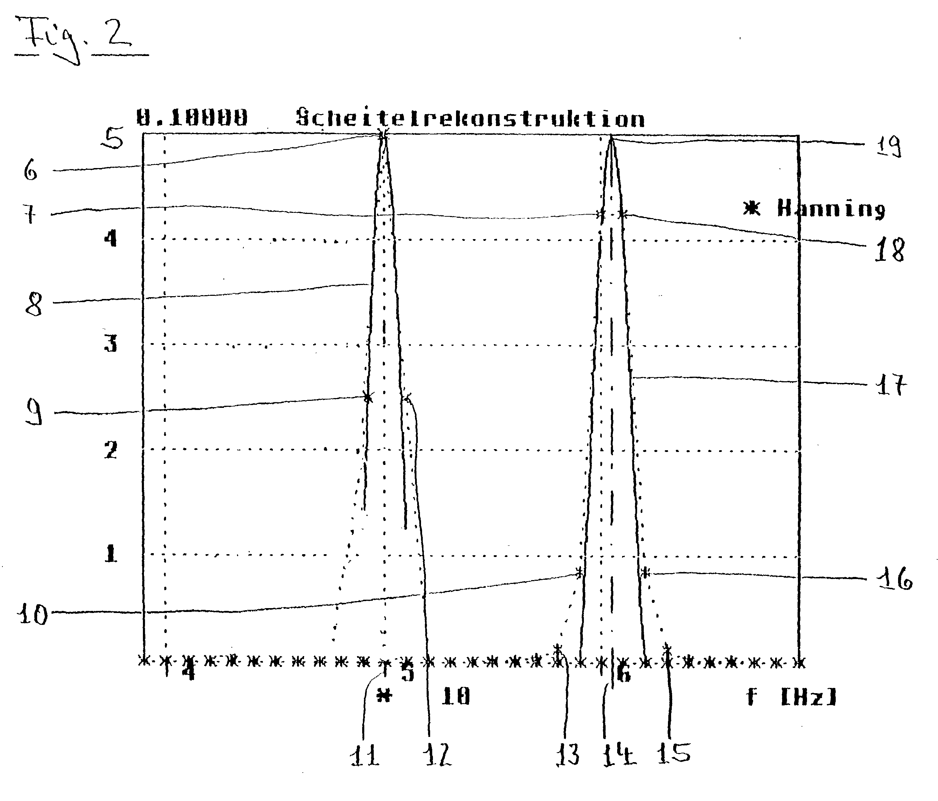

Dieses gewichtete Signal wird nun in einer elektronischen Schaltung des Spektrum-Analysators 3 in den Frequenzbereich transformiert. Ein derartiges Ergebnis eines Frequenzspektrums ist in Fig. 2 der Zeichnung dargestellt. In Fig. 2 sind drei Spektrallinien 6, 9, 12 um die Frequenz bei 50 Hz und sechs Spektrallinien 7, 10, 13, 15, 16, 18 um die Frequenz um 60 Hz erkennbar. Dabei besitzt beispielsweise das Spektrum um 50 Hz ein Maximum 6 mit der Amplitude von 0,5 und um 60 Hz ein Maximum 7 mit der Amplitude von 0,42. Dieses gewichtete Frequenzspektrum wird einer Auswerteeinrichtung 4 zugeführt, die eine Rechenschaltung enthält, die das gewichtete Frequenzspektrum nach dessen Maxima 6, 7 absucht. Diese Rechenschaltung arbeitet nach dem folgenden Algorithmus, der in der Prgrammiersprache "Euler" für das vorgegebene Ausführungsbeispiel programmiert ist. Dieses Programmierungsbeispiel nach "Euler" ist dem Anhang zu dieser Beschreibung zu entnehmen. Dieser Algorithmus könnte aber auch in jeder anderen Programmiersprache programmiert sein.

Die in der Auswerteeinrichtung 4 enthaltene Rechenschaltung ermittelt nach dem Ausführungsbeispiel, das in Fig. 2 der Zeichnung dargestellt ist, zwei Maxima. Zu diesen Maxima werden zwei weitere benachbarte Spektrallinien mit deren Frequenz und Amplitude bzw. Intensität ermittelt. Mittels einer parabolischen Interpolation ergänzt mit eine Asymmetrie-Korrektur ergibt sich für das Spektrum um 50 Hz ein Scheitelwert 6 von 0,5 bei einer Frequenz 11 von exakt 50 Hz.

Bei der Frequenz um 60 Hz ist nach der Hanning-Gewichtung kein eindeutiges Maximum und keine eindeutige Frequenz erkennbar, da die Analysefrequenz nicht eindeutig in das Abtastraster paßt. Nach der Hanning-Gewichtung ergäbe sich eine Amplitude 7 von 0,42 bei den beiden Frequenzen 60 Hz 7 und 60,1 Hz 18.

Nach dem erfinderischen Verfahren kommt jetzt die Asymmetriekorrektur zum Tragen, da die von dem Maximum 7 benachbarten Frequenzen 10, 18 in der Intensität voneinander abweichen. Diese Differenz wird mit einem empirisch ermittelten Korrekturwert multipliziert und zur Verbesserung des Scheitelwertes 19 benutzt. Wie aus Fig. 2 der Zeichnung ersichtlich ist, ergibt die parabolische Interpolation 17 nach dem erfinderischen Verfahren für das Spektrum um 60 Hz eine Analysefrequenz von 60,5 Hz 14 und eine Intensität von 0,5. Da bei den durchgeführten Verfahren beide Intensitäten hätten gleich groß sein müssen, ergibt sich für das interpolierende Verfahren 17 eindeutig eine Verringerung des Fehlers bei der Analysefrequenz, die nicht auf dem Abtastraster liegt.

Die ermittelten Analyseergebnisse werden einer Anzeigevorrichtung 5 zugeführt und nach deren Intensität und Frequenz dargestellt. Diese Ergebnisse können aber auch zur weiteren Auswertung gespeichert und zur Weiterverarbeitung oder Signalisierung anderen Einrichtungen zugeführt werden.

Dieses erfinderische Verfahren und die zur Durchführung vorgesehene Vorrichtung können nicht nur zur Maschinenüberwachung eingesetzt werden, sondern eignen sich für alle Auswertungen von analogen Signalen, deren Beobachtungsabschnitt zeitlich begrenzt ist, dessen Signalerfassungszeitraum nicht periodisch ist und bei dem das analysierbare Signal nicht synchronisiert zur Verfügung steht. Insbesondere sind hierfür solche Meßsignale geeignet, die von einer elektronischen Schaltung oder Meßwandlern stammen und einen Strom, einer Leistung, einem Druck, einer Beschleunigung oder einer sonstigen physikalischen Größe entsprechen.

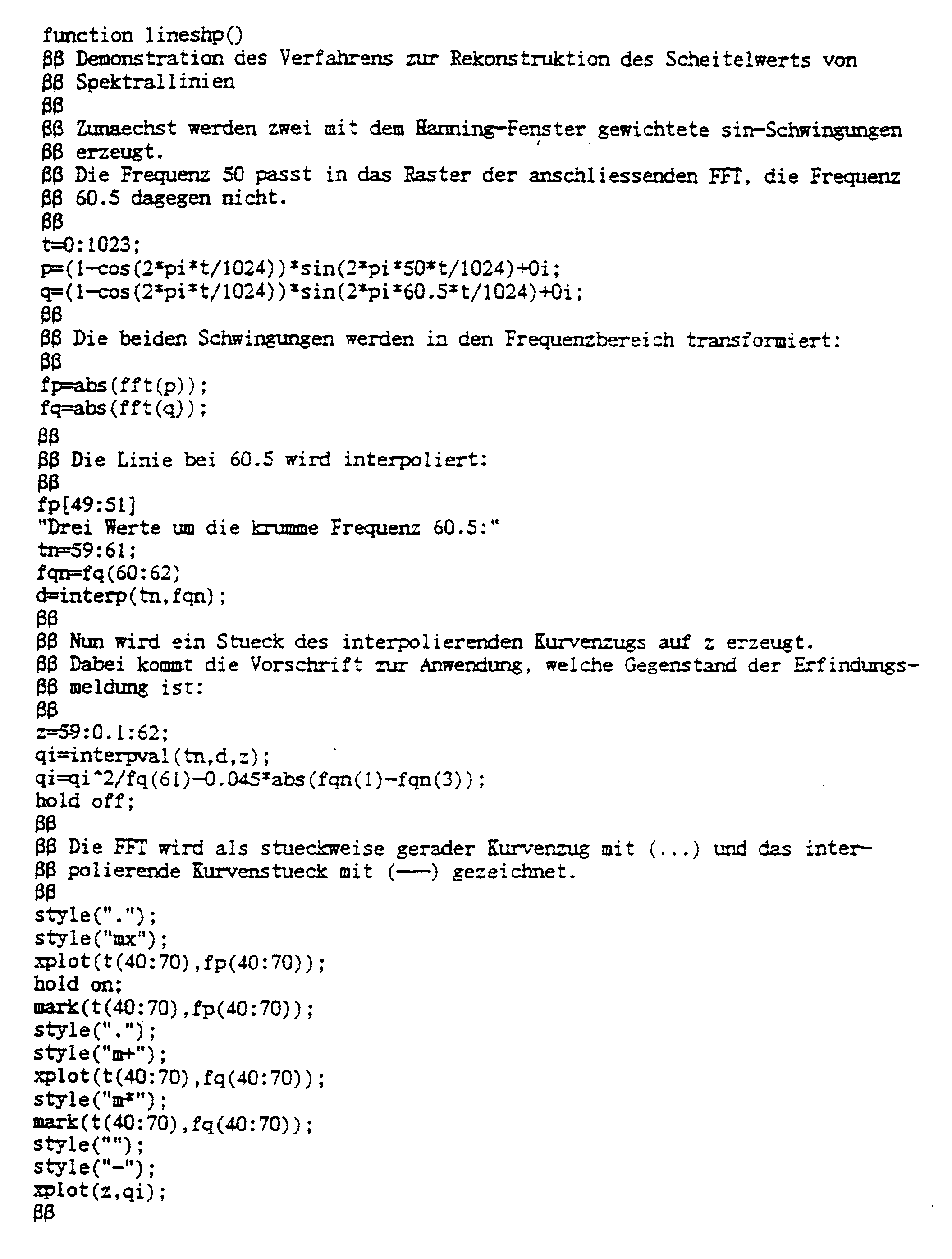

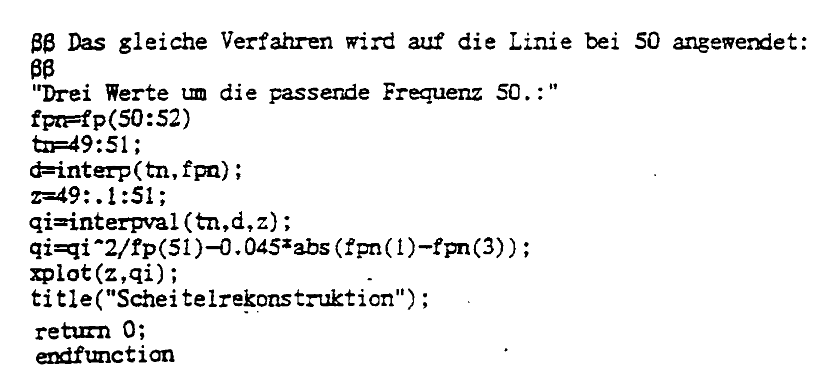

## Patentansprüche

1. Verfahren zur Auswertung eines erfaßten und abgetasteten analogen Meßsignals, das mittels einer Rechenschaltung nach einem bestimmten Algorithmus gefenstert bzw. gewichtet wird, und daraus mittels eines Spektrum-Analysators (3) und einer Auswerteeinrichtung (4) dessen Frequenzspektrum (6, 7, 9, 10, 12, 13, 15; 16, 18) und dessen Maximum bzw. dessen Maxima (6, 7) ermittelt werden, **dadurch gekennzeichnet, daß** aus den Maxima (6, 7) und deren benachbarten Spektrallinien (9, 12; 10, 18) des nach dem Hanning-Algorithmus gefensterten bzw. gewichteten Meßsignals mittels einer parabolischen Interpolation (12, 17) der Leistungsdichte um ein lokales Maximum die Scheitelwerte (6, 19) und deren Frequenz (11, 14) bestimmt und die interpolierten Werte (6, 9, 18; 7, 10, 18) noch einer Asymmetriekorrektur unterzogen werden, wobei die Asymmetriekorrektur aus der Differenz der beiden benachbarten Intensitätswerte (10, 18) und einem empirisch ermittelten Korrekturwert gebildet wird.

2. Vorrichtung zur Durchführung des Verfahrens nach Anspruch 1, **dadurch gekennzeichnet, daß** zur Signalauswertung ein Frequenzanalysator (3) und eine Auswertevorrichtung (4) vorgesehen ist, die als Rechenschaltungen ausgebildet sind, durch die das analoge Meßsignal für einen endlichen Zeitabschnitt nach dem Hanning-Algorithmus gewichtet und in die Frequenzebene transformiert wird und aus dessen Maxima (6, 7) die Scheitelwerte (6, 19) durch eine parabolische Interpolation der Leistungsdichte um ein lokales Maximum interpoliert werden, wobei für die interpolierten Werte in der Rechenschaltung der Auswertevorrichtung 4 eine Asymmetriekorrektur aus der Differenz der beiden benachbarten Intensitätswerte (10, 18) und einem empirisch ermittelten Korrekturwert vorgenommen wird.

## Claims

1. A method for the evaluation of a received and sampled analog test signal, which is windowed and/or weighted according to a particular algorithm by means of a computing circuit and from which its frequency spectrum (6, 7, 9, 10, 12, 13, 15; 16, 18) and its maximum or its maxima (6, 7) are determined by means of a spectrum-analyser (3) and an evaluation arrangement (4), **characterised in that** the peak values (6, 19) and their frequencies (11, 14) are determined from the maxima (6, 7) and their adjacent spectral lines (9, 12; 10, 18) of the test signal windowed and/or weighted according to the Harming algorithm by means of a parabolic interpolation (12, 17) of the power density around a local maximum and the interpolated values (6, 9, 18; 7, 10, 18) are further subjected to an asymmetry correction, wherein the asymmetry correction is formed from the difference of the two adjacent intensity values (10, 18) and an empirically-determined correction value.

2. A device for implementing the method of claim 1, **characterised in that** for signal evaluation there is provided a frequency analyser (3) and an evaluation device (4) which are formed as computing circuits, by means of which the analog test signal for a finite period is weighted according to the Harming algorithm and is transformed into the frequency plane and from its maxima (6, 7) the peak values (6, 19) are interpolated by a parabolic interpolation of the power density about a local maximum wherein for the interpolated values in the computing circuit of the evaluation device (4) there is undertaken an asymmetry correction based on the difference of the two adjacent intensity values (10, 18) and an empirically-determined correction value.

## Revendications

1. Procédé d'exploitation d'un signal de mesure analogique détecté et analysé, qui est mis en fenêtre ou pondéré au moyen d'un circuit de calcul selon un algorithme déterminé, et à partir de ceci son spectre de fréquences (6, 7, 9, 10, 12, 13, 15 ; 16, 18) et son maximum, ou ses maximas (6, 7) sont déterminés au moyen d'un analyseur de spectre (3) et d'un dispositif d'exploitation (4), **caractérisé en ce qu'**à partir des maximas (6, 7) et de leurs lignes spectrales (9, 12 ; 10, 18) voisines du signal de mesure mis en fenêtre ou pondéré selon l'algorithme de Hanning, les valeurs de crête (6, 19) et leur fréquence (11, 14) sont déterminées, au moyen d'une interpolation parabolique (12, 17) de la puissance volumique autour d'un maximum local, et les valeurs interpolées (6, 9, 18 ; 7, 10, 18) sont soumises encore à une correction d'asymétrie, la correction d'asymétrie étant formée à partir de la différence des deux valeurs d'intensité (10, 18) voisines et d'une valeur de correction déterminée empiriquement.

2. Dispositif pour la mise en oeuvre du procédé selon la revendication 1, **caractérisé en ce que** pour l'exploitation du signal, il est prévu un analyseur de fréquence (3) et un dispositif d'exploitation (4) qui sont réalisés en tant que circuits de calcul au moyen desquels le signal de mesure analogique est pondéré pour un intervalle de temps fini selon l'algorithme de Hanning et est transformé dans le plan de fréquence, et à partir de ses maximas (6, 7) les valeurs de crête (6, 19) sont interpolées par une interpolation parabolique de la puissance volumique autour d'un maximum local, tandis qu'une correction d'asymétrie, résultant de la différence des deux valeurs d'intensité (10, 18) voisines et d'une valeur de correction déterminée empiriquement, est effectuée pour les valeurs interpolées dans le circuit de calcul du dispositif d'exploitation (4).
